# EUROPEAN PATENT SPECIFICATION

(11) **EP 3 736 860 B1**
(45) Date of publication and mention of the grant of the patent: **14.10.2026**
(21) Application number: 18898554.3
(22) Date of filing: 17.12.2018
(51) Int. Cl.: H10K 59/35

(54) **PIXEL ARRANGEMENT STRUCTURE, ORGANIC ELECTROLUMINESCENT DISPLAY PANEL AND DISPLAY DEVICE**
PIXELANORDNUNGSSTRUKTUR, ORGANISCHE ELEKTROLUMINESZENTE ANZEIGETAFEL UND ANZEIGEVORRICHTUNG
STRUCTURE D'AGENCEMENT DE PIXELS, PANNEAU D'AFFICHAGE À DIODES ÉLECTROLUMINESCENTES ORGANIQUES ET DISPOSITIF D'AFFICHAGE

(30) Priority: 02.01.2018 CN 201810002818
(43) Date of publication of application: 11.11.2020
(73) Proprietor: BOE TECHNOLOGY GROUP CO., LTD., Beijing 100015 (CN); Chengdu BOE Optoelectronics Technology Co., Ltd., Hi-tech Development Zone Chengdu Sichuan 611731 (CN)
(72) Inventor: DAI, Weinan, Beijing 100176 (CN); WANG, Yang, Beijing 100176 (CN); WANG, Yangpeng, Beijing 100176 (CN); WANG, Benlian, Beijing 100176 (CN); YIN, Haijun, Beijing 100176 (CN); QIU, Haijun, Beijing 100176 (CN); HU, Yao, Beijing 100176 (CN)
(74) Representative: Maiwald GmbH
(86) International application number: PCT/CN2018/121464
(87) International publication number: WO 2019/134495

(56) References cited:
- EP-A1- 3 236 463
- CN-A- 104 898 369
- CN-A- 105 206 647
- CN-A- 107 340 905
- CN-U- 204 885 166
- CN-U- 207 966 982
- CN-U- 207 966 983
- CN-U- 207 966 984
- CN-U- 207 966 985
- CN-U- 207 966 986
- CN-U- 207 966 987
- CN-U- 207 966 994
- CN-U- 207 966 995
- US-A1- 2015 102 320
- US-A1- 2017 278 905

## Description

### CROSS REFERENCE

The present application claims the priority to the Chinese patent application NO. 201810002818.5, filed on Jan. 2, 2018.

### TECHNICAL FIELD

The present disclosure relates to the field of display technologies, and in particular, to a pixel arrangement structure, an organic light emitting diode display panel, and a display device.

### BACKGROUND

Organic Light Emitting Diode (OLED) display means is one of the hotspots in the research field of the flat panel displays nowadays. Compared with the liquid crystal display, OLED display means has the advantages of low power consumption, low production cost, self-illumination, wide viewing angle and fast response. At present, OLED display means has begun to replace the traditional liquid crystal display (LCD) in the field of the flat panel display, such as mobile phone, PDA, and digital camera, etc.

The structure of the OLED display means mainly includes a base substrate, sub-pixels that are manufactured on the base substrate and arranged in a matrix. Among them, each sub-pixel is generally to form an organic light emitting diode structure at a corresponding sub-pixel position on the array substrate through an organic material penetrating a high precision metal mask plate by using evaporation film formation technology.

However, in the current OLED display means, the sub-pixel opening area in the pixel arrangement structure is smaller, thereby it is necessary to increase the drive current to satisfy the brightness requirement of the display. However, OLED operating under a large drive current are easily leaded to an increase of the aging speed of the means, thereby shortening the lifetime of the OLED display means.

EP3236463A1 discloses an organic light emitting display device including a first pixel, and a second pixel being adjacent to the first pixel, wherein each of the first pixel and the second pixel includes a plurality of subpixels, the first pixel and the second pixel share at least one subpixel of the plurality of subpixels.

US2017/278905A1 discloses display device, which includes: a pixel group including a first pixel having a red sub-pixel and a blue sub-pixel; a second pixel having a green sub-pixel and a blue sub-pixel; a third pixel having a green sub-pixel and a blue sub-pixel; and a fourth pixel having a red sub-pixel and a blue sub-pixel. The first pixel is adjacent to the second pixel in a row direction. The first pixel is adjacent to the second pixel in a column direction. The fourth pixel is diagonal to the first pixel, and the fourth pixel is adjacent to the second pixel and the third pixel. In the pixel group, the blue sub-pixels are quantitatively more than the red sub-pixels, and the blue sub-pixels are quantitatively more than the green sub-pixels.

CN204885166U discloses a dot structure including the OLED display panel of this dot structure. Every pixel includes a first sub -pixel, a second sub -pixel, a third sub -pixel and two fourth sub-pixels in this dot structure, the quadrangle is defined by the second sub-pixel, the third sub-pixel and the two fourth sub-pixels, the first sub-pixel is located in the middle of the quadrangle and the second sub-pixel, third sub-pixel and the two fourth sub-pixels are shared by four adjacent pixel units.

CN105206647A discloses a pixel arrangement structure of an OLED display. The pixel arrangement structure includes: a first pixel having a center coinciding with a center of a virtual square; a second pixel separated from the first pixel and having a center at a first vertex of the virtual square; and a third pixel separated from the first pixel and the second pixel, and having a center at a second vertex neighboring the first vertex of the virtual square.

### SUMMARY

It is an object of the present invention to provide , a pixel arrangement structure, an organic light emitting diode display panel, and a display device in the embodiment of the present disclosure to reduce the drive current of the display means, and to increase the lifetime of the display means.

The object is achieved by the features of the respective independent claim. Further embodiments are defined in the corresponding dependent claims.

### BRIEF DESCRIPTION OF THE DRAWINGS

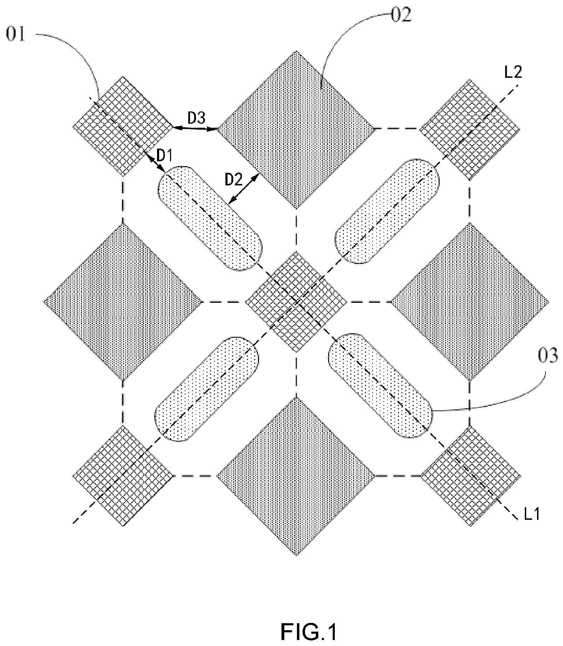

[0030] Fig. 1 is a first schematic view of the pixel arrangement structure provided in an embodiment not according to the claimed invention;
Fig. 2 is a second schematic view of the pixel arrangement structure provided in an embodiment not according to the claimed invention;
Fig. 3 is a third schematic view of the pixel arrangement structure provided in an embodiment not according to the claimed invention;
Fig. 4 is a fourth schematic view of the pixel arrangement structure provided in an embodiment according to the claimed invention;
Fig. 5 is a fifth schematic view of the pixel arrangement structure provided in an embodiment according to the claimed invention;
Fig. 6 is a sixth schematic view of the pixel arrangement structure provided in an embodiment according to the claimed invention;
Fig. 7 is a seventh schematic view of the pixel arrangement structure provided in an embodiment according to the claimed invention;
Fig. 8 is a schematic view of the shape matching of a second sub-pixel and a third sub-pixel in a pixel arrangement structure provided in an embodiment according to the claimed invention;
Fig. 9 is a structure schematic view of an organic light emitting diode display panel provided in an embodiment according to the claimed invention;

### DETAILED DESCRIPTION

In order to make the objects, technical solutions and the advantages of the present disclosure more clear, the present disclosure will be further described in detail below in conjunction with the accompanying drawings. Obviously, the described embodiments are only a part of the embodiments of the present disclosure, and are not all the embodiments. Based on the embodiment of the present disclosure, all the other embodiments obtained by those skilled in the art without making inventive efforts are all within the protection scope of the present disclosure.

The shape and size of each component in the accompanying drawings do not reflect the true proportion. The purpose is merely to schematically illustrate the content of the present disclosure.

A pixel arrangement structure is provided in the embodiment of the present disclosure. As shown in Fig. 1, the pixel arrangement structure includes a plurality of first sub-pixels 01, a plurality of second sub-pixels 02, and a plurality of third sub-pixels 03. The positions of the above all sub-pixels are not overlapped with each other;

One of the plurality of first sub-pixels 01 is located at the center position of a first virtual rectangle, and four of the plurality of first sub-pixels 01 are located at four vertex angle positions of the first virtual rectangle respectively;

Four of the plurality of second sub-pixels 02 are located at the center positions of four sides of the first virtual rectangle respectively;

The first virtual rectangle is divided into four second virtual rectangles, and the inside of each of the four second virtual rectangles each includes one third sub-pixel 03 of the plurality of third sub-pixels 03.

It should be understood that the center position and the vertex angle position mentioned in the present disclosure are approximate positions, and not limited to the center point or the vertex. The existence of certain deviation is allowed, and only the area of the corresponding sub-pixels should cover the center point or the vertex.

Compared with the pixel arrangement structure of the related art, the pixel arrangement structure provided by the embodiment of the present disclosure can make the first sub-pixel 01, the second sub-pixel 02, and the third sub-pixel 03 be closely arranged under the same process conditions. Therefore, under the condition that the minimum sub-pixel interval is satisfied, the area of the single sub-pixel is increased as much as possible, thereby reducing the drive current of the display means and increasing the lifetime of the display means.

In the embodiment of the present disclosure, the second virtual rectangle is formed by sequentially connecting the four vertex angles, and the four vertex angles include two second sub-pixels 02 and two first sub-pixels 01. The two second sub-pixels 02 are located at center positions of two adjacent sides of the first virtual rectangle. Each of the two first sub-pixels 01 is adjacent to each of the two second sub-pixels 02, and one of the two first sub-pixels 01 is located at the center position of the first virtual rectangle and the other is located at a vertex angle position of the first virtual rectangle.

In the embodiment of the present disclosure, each of the third sub-pixels 03 is in a long strip shape, and the extension direction of the long strip shape is a direction which is away from the center of the first virtual rectangle.

In an embodiment, the extension direction of each third sub-pixel 03 inside of the four second virtual rectangles is different. In the present embodiment, the extension direction of each third sub-pixel 03 inside of the four second virtual rectangles is a direction which is away from the first sub-pixel 01 located at the center of the first virtual rectangle and extending in the corresponding second virtual rectangle.

The long strip shape is a mirror symmetrical view in the direction perpendicular to the extension direction thereof.

Arranging the third sub-pixel 03 in a long strip shape is beneficial to enlarge the area of the second sub-pixel 02, thereby the sub-pixel with low luminous efficiency in the display panel can be set as the second sub-pixel 02. In addition, the two ends of the long strip are symmetrically designed, which can reduce the pattern complexity of the evaporation mask plate, thereby simplifying the pattern composition process.

It should be noted that, in the pixel arrangement structure provided in the embodiment of the present disclosure, the mentioned sub-pixel locating at a certain position is referred to a position scope of the sub-pixel locating, and just make sure the sub-pixel overlap with the position. In particularly embodiment, the center of the sub-pixel may be overlapped with the position. Of course, the center of the sub-pixel may be not overlapped with the position. That is, a deviation is existed between the center of the sub-pixel and the position, which is not limited herein. Moreover, the center of the sub-pixel may be the geometric center of the sub-pixel pattern, and may also be the center of the emitting color of the sub-pixel, which is not limited herein.

Optionally, in the pixel arrangement structure provided in the embodiment of the present disclosure, in order to ensure that each sub-pixel can be evenly distributed, the center of each sub-pixel is made as close as possible to the corresponding position.

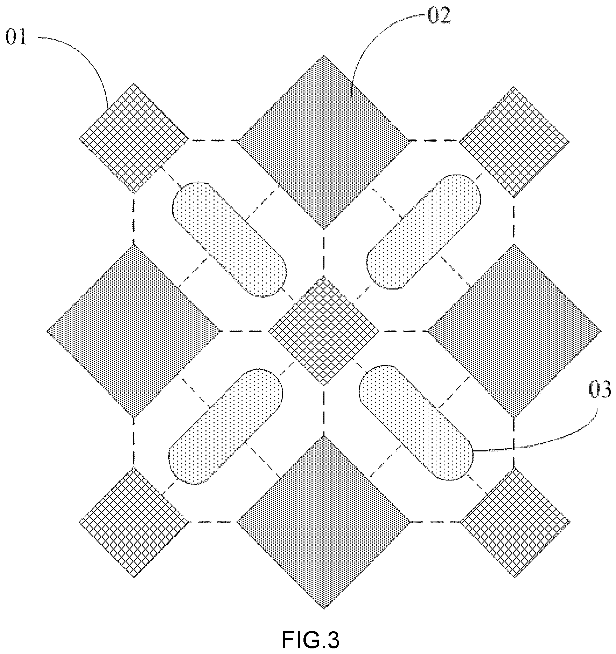

Optionally, in the pixel arrangement structure provided in the embodiment of the present disclosure, as shown in Fig. 1 to Fig. 7, the extension directions of the third sub-pixels 03 in the two second virtual rectangles which disposed along a diagonal of the first virtual rectangle are consistent.

In an embodiment, the first virtual rectangle is provided with a first diagonal line L1 and a second diagonal line L2. The third sub-pixels 03 in the two second virtual rectangles which disposed along the first diagonal line L1 are extended in the direction along the first diagonal line L1. The third sub-pixels 03 in the two second virtual rectangles which disposed along the second diagonal line L2 are extended in the direction along the second diagonal line L2.

In an embodiment, the third sub-pixels 03 in the two second virtual rectangles which disposed along the first diagonal line L1 are mirror symmetry with respect to the second diagonal line L2. The third sub-pixels 03 in the two second virtual rectangles which disposed along the second diagonal line L2 are mirror symmetry with respect to the first diagonal line L1.

The third sub-pixels 03 in the four second virtual rectangles constituting the first virtual rectangle are distributed in an "X" shape. That is, both ends of each third sub-pixel 02 are respectively pointed to the third sub-pixels 03 located at the two vertex angle positions of the second virtual rectangle in which the third sub-pixels 03 located.

It should be noted that, the first virtual rectangle mentioned in the display arrangement structure provided by the embodiment of the present disclosure is the largest dotted frame in Fig. 1, and the second virtual rectangle is a small dotted frame in Fig. 1. In Fig. 1, the first virtual rectangle includes four second virtual rectangles. The first virtual rectangle and the second virtual rectangle may be rectangular, may also be square, which is not limited herein.

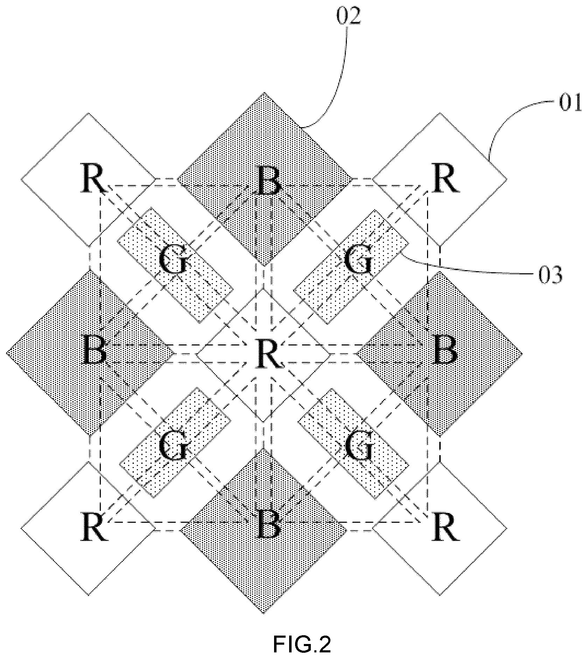

Optionally, in the pixel arrangement structure provided in the embodiment of the present disclosure, the first sub-pixel is a red sub-pixel, and the second sub-pixel is a blue sub-pixel. Or, the first sub-pixel is a blue sub-pixel, and the second sub-pixel is a red sub-pixel. The third sub-pixel is a green sub-pixel. Thus as shown in Fig. 2, the green sub-pixel G located at the inside of the second virtual rectangle may constitute a luminous pixel point with the red sub-pixel R and the blue sub-pixel B located at any two adjacent vertex angles of the second virtual rectangle.

Further, since the luminous efficiency of the blue sub-pixel is lower, and the lifetime of the blue sub-pixel is shorter, optionally, in the pixel arrangement structure provided in the embodiment of the present disclosure, as shown in Fig. 2, the first sub-pixel 01 is a red sub-pixel R, the second sub-pixel 02 is a blue sub-pixel B, and the third sub-pixel 03 is a green sub-pixel G. Thus the green sub-pixel G with strip shape can expand the area of the blue sub-pixel B toward the direction of the green sub-pixel G. Thereby, the area of the blue sub-pixel B is larger than the area of the red sub-pixel R and the area of the green sub-pixel G, respectively.

In an embodiment, the area of the blue sub-pixel B is larger than the area of the red sub-pixel R, and the area of the red sub-pixel R is larger than the area of the green sub-pixel G. In another embodiment, the area of the blue sub-pixel B is larger than the area of the green sub-pixel G, and the area of the green sub-pixel G is larger than the area of the red sub-pixel R.

Further, in the pixel arrangement structure provided in the embodiment of the present disclosure, since the luminous efficiency of the green sub-pixel is generally higher, the area of the green sub-pixel may be set to be smaller than the area of the red sub-pixel. Of course, in the specific implementation, the area of the green sub-pixel may also be the same as the area of the red sub-pixel, which is not limited herein.

It should be noted that the above-mentioned "area of the sub-pixel" and size thereof are aimed at sub-pixels area included in a first virtual rectangle. Since the sub-pixels on the sides and vertex angle of the first virtual rectangle are all shared with the adjacent first virtual rectangle, the area ratio of the pixels in one first virtual rectangle is different from the area ratio of the pixels in the overall panel.

For the overall panel, the total area ratio of the RGB sub-pixels may be, for example, 1:1.1~1.5:1.2~1.7. Further, the total area ratio of the RGB sub-pixels may be 1:1.2~1.35: 1.4~1.55. Further, the total area ratio of the RGB sub-pixels may be 1:1.27: 1.46. The total number ratio of RGB sub-pixels is 1:2:1.

Optionally, in the above-mentioned pixel arrangement structure provided in the embodiment of the present disclosure, there is a first ratio between the minimum distance D1 which is between the opposite sides of the third sub-pixel 03 and the adjacent first sub-pixel 01, and the minimum distance D2 which is between the opposite sides of the third sub-pixel and the adjacent second sub-pixel. There is a second ratio between the minimum distance D1 which is between the opposite sides of the third sub-pixel and the adjacent first sub-pixel and the minimum distance D3 which is between the opposite sides of the first sub-pixel and the adjacent second sub-pixel. And there is a third ratio between the minimum distance D2 which is between the opposite sides of the third sub-pixel and the adjacent second sub-pixel, and the minimum distance D3 which is between the opposite sides of the first sub-pixel and the adjacent second sub-pixel . The first ratio, the second ratio, and the third ratio are all in the range of 0.8-1.2, such as 0.9, 1, 1.1.

Optionally, two or three among the first ratio, the second ratio and the third ratio are equal.

Optionally, the each first sub-pixel, the each second sub-pixel, and the each third sub-pixel are arranged substantially equidistantly with respect to each other.

As shown in Fig. 1, the minimum distance refers to the shortest distance between the opposite sides. The opposite sides may be straight lines or curved lines, and the opposite sides are parallelizable.

In other words, the minimum distance needs to be greater than or equal to the process limit distance, and the minimum distance between the opposite sides of the third sub-pixel 03 and the adjacent second sub-pixel 02 needs to be greater than or equal to the process limit distance to satisfy the process requirements.

Optionally, in the above-mentioned pixel arrangement structure provided by the embodiment of the present disclosure, the ratio of a maximum distance between the opposite sides of the third sub-pixel and the adjacent first sub-pixel to a minimum distance between the opposite sides of the third sub-pixel and the adjacent first sub-pixel is in a range of 1~1.5, for example, 1.1, 1.2, 1.3, 1.4, etc.

Optionally, in the above-mentioned pixel arrangement structure provided by the embodiment of the present disclosure, the ratio of a maximum distance between the opposite sides of the third sub-pixel and the adjacent second sub-pixel to a minimum distance between the opposite sides of the third sub-pixel and the adjacent second sub-pixel is in a range of 1~1.5, for example, 1.1, 1.2, 1.3, 1.4, etc.

Optionally, in the pixel arrangement structure provided in the embodiment of the present disclosure, in order to enable the third sub-pixel 03 to be evenly distributed in the pixel arrangement structure to reduce the spacing between the third sub-pixel 03 and the adjacent first sub-pixel 01, and to reduce the spacing between the third sub-pixel 03 and the adjacent second sub-pixel 02, as shown in Fig. 2 to Fig. 7, the center of the third sub-pixel 03 of each second virtual rectangle is located at the intersection of the line connecting of the centers of the adjacent two first sub-pixels 01 and the line connecting of the centers of the adjacent two second sub-pixels 02 of the corresponding second virtual rectangle, that is, located at the center of the second virtual rectangle.

Optionally, in the pixel arrangement structure provided in the embodiment of the present disclosure, in order to ensure that the gap width between the third sub-pixel 03 and the adjacent first sub-pixel 01 is consistent to reduce the spacing between the third sub-pixel 03 and the adjacent first sub-pixel 01, as shown in Fig. 1 to Fig. 7, the opposite sides of the third sub-pixel 03 and the adjacent first sub-pixels 01 are parallel to each other. Of course, in the specific implementation, the opposite sides of the third sub-pixel 03 and the adjacent first sub-pixel 01 may also be not parallel, which is not limited herein.

It should be noted that, in the pixel arrangement structure provided in the embodiment of the present disclosure, the shape of the sub-pixel is referred to a shape with the existence of certain process fluctuations and errors. For a high-resolution display panel, since the sub-pixel itself has a smaller area, a method commonly used in the art can be adopted for the correction or compensation of the mask plate pattern to obtain a precise sub-pixel pattern.

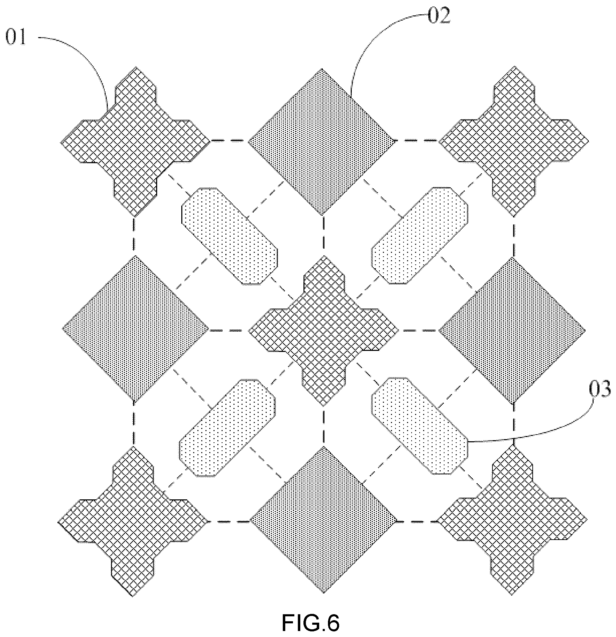

In the specific implementation, the inner angle of the sub-pixel shape is larger, or closer to the circular arc, the easier it is to realize during evaporating. Therefore, optionally, in the pixel arrangement structure provided in the embodiment of the present disclosure, as shown in Fig. 1, Fig. 3 to Fig. 5, the two ends of the long strip shape are circular arc shape that protrudes outward from the interior of the long strip shape; Or as shown in Fig. 6 to Fig. 8, both ends of the long strip are polygons, for example, isosceles trapezoid of Fig. 6 to Fig. 8. Of course, In the specific implementation, the shape of the long strip may also be rectangle as shown in Fig. 2, which is not limited herein.

Optionally, in the pixel arrangement structure provided in the embodiment of the present disclosure, as shown in Fig. 1 to Fig. 3, the shape of the first sub-pixel 01 is a substantial rectangle. Of course, other regular patterns or irregular patterns may also be used, which is not limited herein.

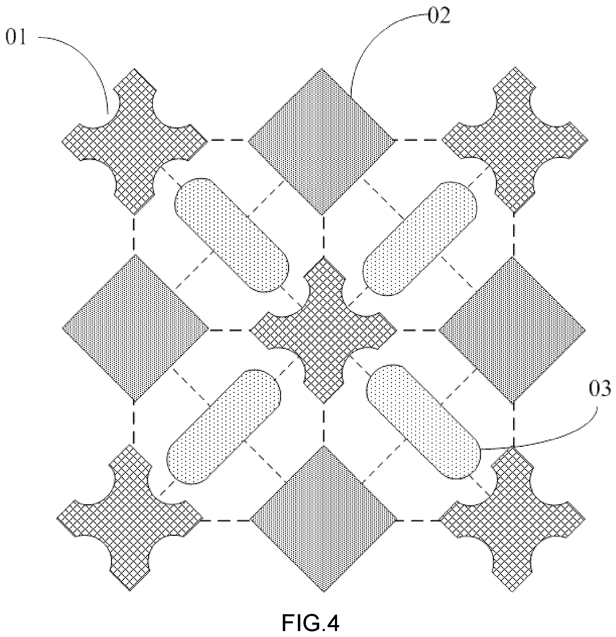

Optionally, in the pixel arrangement structure provided in the embodiment of the present disclosure, as shown in Fig. 4 to Fig. 8, the shape of the first sub-pixel 01 is a substantial cruciform. Thus the first sub-pixel 01 and the third sub-pixel can be closely arranged, and color mixing can be avoided on the basis of ensuring the sub-pixel area.

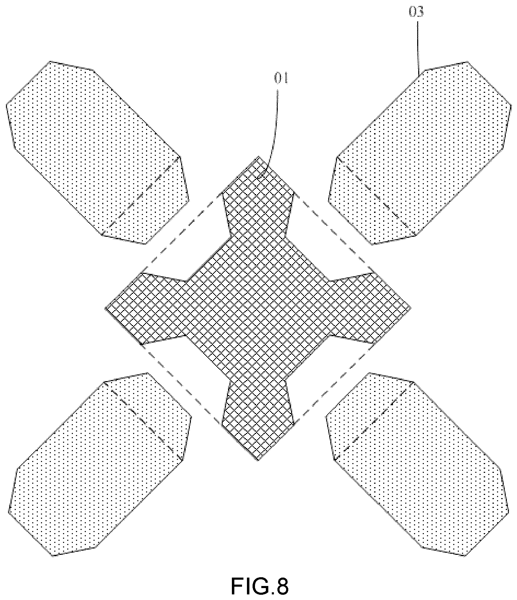

Specifically, in the inventive embodiments, as shown in Fig. 8, the cruciform is a shape formed by the concave of the middle of the four sides of the quadrilateral, and the four vertex angles of the quadrilateral are as four ends of the cruciform respectively, among them, the quadrilateral is a substantial diamond shape or a substantial square. The specific concave depth and shape are matched with the two ends of the long strip of the third sub-pixel 03 with long strip shape.

Optionally, in the pixel arrangement structure provided in the embodiment of the present disclosure, as shown in Fig. 4 to Fig. 7, each inner angle of the first sub-pixel 01 is greater than or equal to 90 degrees. The larger each inner angle of the first sub-pixel 01, the easier to realize evaporating. On the contrary, if the inner angle of the sub-pixel is smaller, it needs to make compensation for the mask plate pattern for preparing a sub-pixel shape with a smaller inner angle. Therefore, the pattern complexity of the mask plate can be reduced by making the inner angle of the first sub-pixel 01 greater than or equal to 90 degrees.

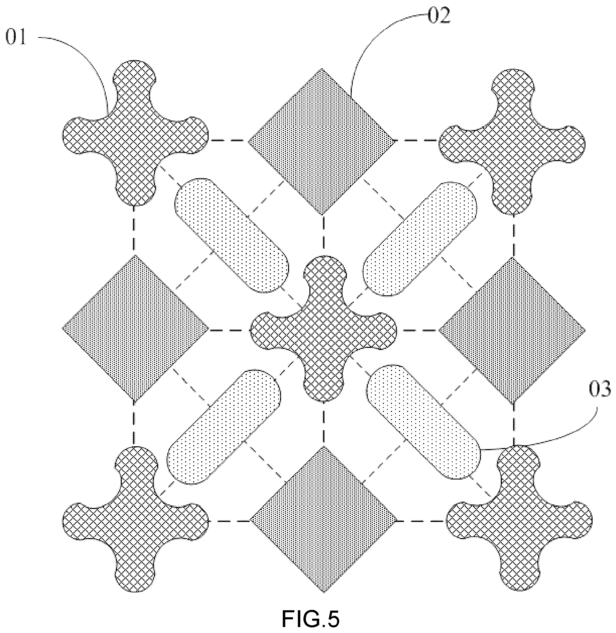

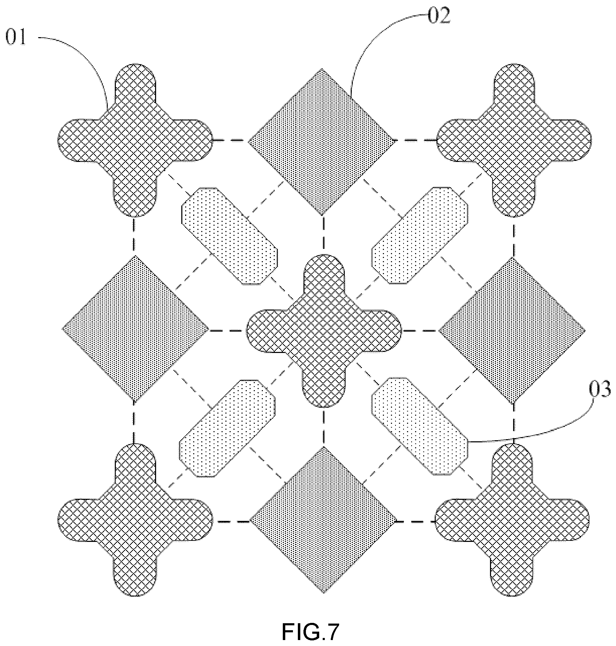

Optionally, in the pixel arrangement structure provided in the embodiment of the present disclosure, as shown in Fig. 5 and Fig. 7, the four vertex angles of the substantial rhombus or the substantial square are rounded corners. That is, the four ends of the cruciform are all rounded corners or all circular arc shape.

Optionally, in the pixel arrangement structure provided in the embodiment of the present disclosure, in order to ensure that the gap width between the third sub-pixel 03 and the adjacent second sub-pixel 02 is consistent to reduce the spacing between the third sub-pixel 03 and the adjacent second sub-pixel 02. As shown in Fig. 1 to Fig. 7, the opposite sides of the third sub-pixel 03 and the adjacent second sub-pixel 02 are parallel to each other.

Specifically, in the pixel arrangement structure provided in the embodiment of the present disclosure, since the third sub-pixel 03 is in a long strip shape, and the opposite sides of the third sub-pixel 03 and the adjacent second sub-pixel 02 are parallel to each other, setting the opposite sides of the third sub-pixel 03 and the adjacent second sub-pixel 02 to be straight line shape can simplify the pattern complexity of the mask plate as much as possible. Therefore, optionally, in the pixel arrangement structure provided in the embodiment of the present disclosure, as shown in Fig. 1 to Fig. 7, the shape of the second sub-pixel 02 is a substantial rectangle.

Of course, In the specific implementation, the opposite sides of the third sub-pixel 03 and the adjacent second sub-pixel 02 may also be not parallel, which is not limited herein.

Optionally, in the pixel arrangement structure provided in the embodiment of the present disclosure, the minimum spacing between the third sub-pixel and the first sub-pixel is equal to the minimum spacing between the third sub-pixel and the second sub-pixel.

Moreover, the minimum spacing is generally the process limit distance, and the numerical range of the minimum spacing is generally related to the used manufacturing process. When a fine metal mask plate (FMM) matched with the etching process is adopted to form the sub-pixel shape, the minimum spacing is about 16µm, and the minimum spacing will be smaller when a laser or electroforming process is adopted to form the sub-pixel shape.

Optionally, in the pixel arrangement structure provided in the embodiment of the present disclosure, the minimum spacing between the any adjacent two first sub-pixel and the second sub-pixel is equal.

Optionally, in the pixel arrangement structure provided in the embodiment of the present disclosure, as shown in Fig. 1 to Fig. 7, the area of each third sub-pixel 03 is the same, thereby ensuring that in any luminous pixel point composed by the first sub-pixel 01, the second sub-pixel 02 and the third sub-pixel 03, the luminous area of the third sub-pixel 03 is all the same.

Of course, in the specific implementation, in the pixel arrangement structure provided in the embodiment of the present disclosure, the areas of at least two third sub-pixels may also be not same, which is not limited herein.

During the manufacturing process, in order to ensure that the mask pattern can be consistent for the same kind of sub-pixel, thereby capable of simplifying the pattern composition process, optionally, in the pixel arrangement structure provided in the embodiment of the present disclosure, as shown in Fig. 1 to Fig.7, the shape of each third sub-pixel 03 is consistent.

Of course, in the specific implementation, in the pixel arrangement provided by the embodiment of the present disclosure, the shapes of at least two third sub-pixels may also be not consistent, which is not limited herein.

Optionally, in the pixel arrangement structure provided in the embodiment of the present disclosure, as shown in Fig. 1 to Fig. 7, the area of each second sub-pixel 02 is the same, thereby ensuring that in any luminous pixel point composed by the first sub-pixel 01, the second sub-pixel 02 and the third sub-pixel 03, the luminous area of the second sub-pixel 02 is all the same.

Of course, in the specific implementation, in the pixel arrangement structure provided in the embodiment of the present disclosure, the areas of at least two second sub-pixels may also be not the same, which is not limited herein.

During the manufacturing process, in order to ensure that the mask pattern can be consistent for the same kind of sub-pixel, thereby capable of simplifying the pattern composition process, optionally, in the pixel arrangement structure provided in the embodiment of the present disclosure, as shown in Fig.1 to Fig.7, the shape of each second sub-pixel 02 is consistent.

Of course, in the specific implementation, in the pixel arrangement structure provided in the embodiment of the present disclosure, the shape of at least two second sub-pixels may also be not consistent, which is not limited herein.

Moreover, optionally, in the above-mentioned pixel arrangement provided by the embodiment of the present disclosure, when the shapes of the four second sub-pixels 02 in a first virtual rectangle are the same or similar, the arrangement angles thereof may be the same, and the arrangement angles thereof may also be rotated arbitrarily, which is not limited herein.

Optionally, in the pixel arrangement structure provided in the embodiment of the present disclosure, as shown in Fig. 1 to Fig. 7, the area of each first sub-pixel 01 is the same, thereby ensuring that in any luminous pixel point composed by the first sub-pixel 01, the second sub-pixel 02 and the third sub-pixel 03, the luminous area of the first sub-pixel 01 is all the same.

In the specific implementation, in the pixel arrangement structure provided in the embodiment of the present disclosure, the areas of at least two first sub-pixels may also not be the same, which is not limited herein.

During the manufacturing process, in order to ensure that the mask pattern can be consistent for the same kind of sub-pixel, thereby capable of simplifying the pattern composition process, optionally, in the pixel arrangement structure provided in the embodiment of the present disclosure, as shown in Fig.1 to Fig.7, the shape of each first sub-pixel 01 is consistent.

In the specific implementation, in the pixel arrangement structure provided in the embodiment of the present disclosure, the shapes of at least two first sub-pixels may also be not consistent, which is not limited herein.

Moreover, optionally, in the above-mentioned pixel arrangement structure provided by the embodiment of the present disclosure, when the shapes of the five first sub-pixels 01 in a first virtual rectangle are the same or similar, the arrangement angles thereof may be the same, and the arrangement angles thereof may also be rotated a rbitrarily, which is not limited herein.

Optionally, the specific shapes, position relationships, parallel and angle relationships of the second sub-pixel 02, the first sub-pixel 01 and the third sub-pixel 03 can be designed as needed. In the actual process, due to the limitation of the process conditions or other factors, there may also be some deviation. Therefore, the shape, position and relative position relationship of each sub-pixel only needs to substantially satisfy the above-mentioned conditions, which all belong to the pixel arrangement structure provided by the embodiment of the present disclosure.

It should be noted that, the pattern inconformity of the sub-pixels mentioned in the embodiment of the present disclosure are referred to the shapes inconformity of the sub-pixels, for example, one is a circle and one is a rectangle. On the contrary, the pattern conformity of the sub-pixels mentioned in the embodiment of the present disclosure are referred to the shape similarity or identity of the sub-pixels. For example, the shapes of the two sub-pixels are both triangles, regardless of whether the areas are equal or not, then the shapes of the two sub-pixels is considered to be consistent.

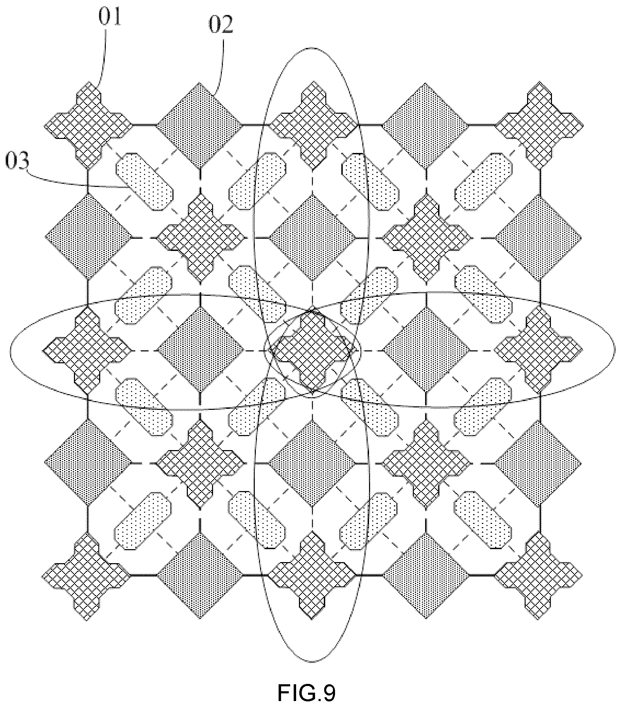

Based on the same disclosed conception, an organic light emitting diode display panel is further provided in the embodiment of the present disclosure, as shown in Fig. 9, the display panel includes a plurality of closely arranged pixel arrangement structures (taking four pixel arrangement structures as an example in Fig. 9). The pixel arrangement structure may be any one kind of the above-mentioned pixel arrangement structures provided by the embodiment of the present disclosure. The adjacent first virtual rectangles are configured to share the sub-pixel on respective facing sides in the row direction and the column direction. That is, the first sub-pixel 01 and the second sub-pixel 02 located on the sides of the adjacent first virtual rectangles are shared by the adjacent two pixel arrangement structures. For example, three sub-pixels circled by each ellipse in Fig. 9 are sub-pixels shared by two adjacent pixel arrangement structures. Since the principle of solving the problem by the organic light emitting diode display panel is similar to the foregoing pixel arrangement structure, the implementation of the organic light emitting diode display panel can be referred to the implementation of the foregoing pixel arrangement structure, and there is no more repeated detailed description.

Specifically, the organic light emitting diode display panel is provided in the embodiment of the present disclosure, as shown in Fig. 9, the first sub-pixel 01 and the second sub-pixel 02 are alternately arranged in the row direction, and the first sub-pixel 01 and the second sub-pixel 02 are alternately arranged in the column direction, and the third sub-pixel 01 is located in the second virtual rectangle surrounded by two first sub-pixels 01 and two second sub-pixels 02. Thus, when displaying, any adjacent two first sub-pixel 01 and second sub-pixel 02 can constitute a luminescent pixel point with a third sub-pixel 03 adjacent thereto. Among the sub-pixels, a high-resolution display effect is achieved from a physical resolution with low-resolution by the lend color principle.

Based on the same disclosed conception, a display device is further provided in the embodiment of the present disclosure, the display device includes any one kind above-mentioned organic light emitting diode display panel provided in the embodiment of the present disclosure. The display device can be any product or component with a display function, such as a mobile phone, a tablet computer, a television, a displayer, a notebook computer, a digital photo frame, a navigator, etc. The implementation of the display device can be referred to the embodiment of the foregoing display panel, and there is no more repeated detailed description.

Based on the same disclosed conception, a mask plate assembly is further provided by the embodiment of the present disclosure, that is not according to the claims, such as a high precision metal mask plate, which is used for manufacturing the above-mentioned any one kind pixel arrangement structure provided by the embodiment of the present disclosure. The mask plate assembly includes a first mask plate, a second mask plate and a third mask plate. The first mask plate has a plurality of first open regions, and the first open regions are corresponding to the shape and position of the first sub-pixel. The second mask plate has a plurality of second open regions, and the second open regions are corresponding to the shape and position of the second sub-pixel. The third mask plate has a plurality of third open regions, and the third open regions are corresponding to the shape and position of the third sub-pixel. Since the principle of solving the problem by the mask plate is similar to the foregoing pixel arrangement structure, thus the implementation of the mask plate can be referred to the implementation of the foregoing pixel arrangement structure, and there is no more repeated detailed description.

The above-mentioned pixel arrangement structure, organic light emitting diode display panel, mask plate and display device are provided in the embodiment of the present disclosure. In an embodiment, in the pixel arrangement structure, the first sub-pixels are located at the center position of the first virtual rectangle and the positions of four vertex angles of the first virtual rectangle; the second sub-pixels are located at the center position of the sides of the first virtual rectangle; and the third sub-pixel is located in the second virtual rectangle. The second virtual rectangle are sequentially connected by two second sub-pixels and two first sub-pixels, the two second sub-pixels and the two first sub-pixels are as vertex angles, the two second sub-pixels are located at center position of the adjacent two sides of the first virtual rectangle, and each of the two first sub-pixels is adjacent to each of the two second sub-pixels and one of the two first sub-pixels is located at the center position of the first virtual rectangle and the other is located at a vertex angle position of the first virtual rectangle. And four second virtual rectangles are formed a first virtual rectangle. Compared with the pixel arrangement structure of the related art, such pixel arrangement manner can make the first sub-pixel, the second sub-pixel and the third sub-pixel closely arranged under the same process condition. Thereby under the condition that the minimum sub-pixel interval is satisfied, the area of the single sub-pixel is increased as much as possible, thereby reducing the drive current of the display means and increasing the lifetime of the display means.

Moreover, arranging the third sub-pixel in a long strip shape is beneficial to enlarge the area of the second sub-pixel, thereby the sub-pixel with lower luminous efficiency in the display panel can be set as the second sub-pixel. In addition, the two ends of the long strip are symmetrical designed, which can reduce the pattern complexity of the evaporation mask plate, thereby simplifying the pattern composition process.

## Claims

1. A pixel arrangement structure, comprising: a plurality of first sub-pixels (01), a plurality of second sub-pixels (02) and a plurality of third sub-pixels (03), the positions of the above all sub-pixels are not overlapped with each other;
one of the plurality of first sub-pixels (01) is located at the center position of a first virtual rectangle, and four of the plurality of first sub-pixels (01) are located at four vertex angle positions of the first virtual rectangle respectively;
four of the plurality of second sub-pixels (02) are located at the center positions of four sides of the first virtual rectangle respectively;
the first virtual rectangle is divided into four second virtual rectangles, and the inside of each of the four second virtual rectangles comprising one third sub-pixel (03) of the plurality of third sub-pixels (03);
the second virtual rectangle is formed by sequentially connecting four vertex angles, and the four vertex angles comprise two second sub-pixels (02) and two first sub-pixels (01); the two second sub-pixels (02) are located at the center positions of two adjacent sides of the first virtual rectangle, each of the two first sub-pixels (01) is adjacent to each of the two second sub-pixels (02), and one of the two first sub-pixels (01) is located at the center position of the first virtual rectangle and the other is located at a vertex angle position of the first virtual rectangle;
each first sub-pixel (01) has a shape of a rhombus or a square with the middle of four sides having a concave portion;
**characterized in that** the concave depth and shape of the concave portion are matched with the two ends of the long strip of the third sub-pixel having a long-strip shape (03).

2. The pixel arrangement structure of claim 1, wherein the first virtual rectangle has a first diagonal line and a second diagonal line, the third sub-pixels (03) in the two second virtual rectangles disposed along the first diagonal line are extended along the first diagonal line, and the third sub-pixels (03) in the two second virtual rectangles disposed along the second diagonal line are extended along the second diagonal line.

3. The pixel arrangement structure of claim 2, wherein the long strip shape is mirror symmetrical with respect to a symmetry axis along a direction perpendicular to the extension direction of the long strip shape.

4. The pixel arrangement structure of claim 2, wherein the third sub-pixels (03) in the two second virtual rectangles which disposed along the first diagonal line are mirror symmetry with respect to the second diagonal line; the third sub-pixels (03) in the two second virtual rectangles which disposed along the second diagonal line are mirror symmetry with respect to the first diagonal line.

5. The pixel arrangement structure of claim 2, wherein there is a first ratio between the minimum distance (D1) which is between the opposite sides of the third sub-pixel (03) and the adjacent first sub-pixel (01), and the minimum distance (D2) which is between the opposite sides of the third sub-pixel (03) and the adjacent second sub-pixel (02); there is a second ratio between the minimum distance (D1) which is between the opposite sides of the third sub-pixel (03) and the adjacent first sub-pixel (01), and the minimum distance (D3) which is between the opposite sides of the first sub-pixel (01) and the adjacent second sub-pixel (02); there is a third ratio between the minimum distance (D2) which is between the opposite sides of the third sub-pixel (03) and the adjacent second sub-pixel (02), and the minimum distance (D3) which is between the opposite sides of the first sub-pixel (01) and the adjacent second sub-pixel (02); the first ratio, the second ratio and the third ratio are all in the range of 0.8-1.2.

6. The pixel arrangement structure of claim 5, wherein, the first ratio, the second ratio and the third ratio are equal.

7. The pixel arrangement structure of claim 5, wherein the ratio of a maximum distance between the opposite sides of the third sub-pixel (03) and the adjacent first sub-pixel (01) to a minimum distance between the opposite sides of the third sub-pixel (03) and the adjacent first sub-pixel (01) is in a range of 1~1.5;
the ratio of a maximum distance between the opposite sides of the third sub-pixel (03) and the adjacent second sub-pixel (02) to a minimum distance between the opposite sides of the third sub-pixel (03) and the adjacent second sub-pixel (02) is in a range of 1~1.5.

8. The pixel arrangement structure of claim 5, wherein the opposite sides of the third sub-pixel (03) and the adjacent first sub-pixels (01) are parallel to each other; the opposite sides of the third sub-pixel (03) and the adjacent second sub-pixels (02) are parallel to each other.

9. The pixel arrangement structure of claim 1, wherein each inner angle of the first sub-pixel (01) is greater than or equal to 90 degrees, preferably, the four vertex angles of the rhombus or the square are rounded corners.

10. The pixel arrangement structure of claim 1, wherein the first sub-pixel (01) is a red sub-pixel; the second sub-pixel (02) is a blue sub-pixel; the third sub-pixel (03) is a green sub-pixel;
the area of the blue sub-pixel is larger than the area of the red sub-pixel and the area of the green sub-pixel, respectively.

11. The pixel arrangement structure of claim 2, wherein the center of the third sub-pixel (03) of each second virtual rectangle is located at the intersection of the line connecting of the centers of the adjacent two first sub-pixels (01) of the corresponding second virtual rectangle and the line connecting of the centers of the adjacent two second sub-pixels (02) of the corresponding second virtual rectangle.

12. An organic light emitting diode display panel, comprising the plurality of pixel arrangement structures according to any one of claims 1-11;
wherein the adjacent first virtual rectangles are configured to share the sub-pixels on respective facing sides in the row direction and the column direction.

13. The organic light emitting diode display panel of claim 12,
wherein, for the overall panel, a total area ratio of the first sub-sub-pixels (01), the second sub-pixels (02) and the third sub-pixels (03) is 1:(1.1-1.5):(1.2-1.7).

## Patentansprüche

1. Eine Pixelanordnungsstruktur, umfassend: eine Vielzahl von ersten Subpixeln (01), eine Vielzahl von zweiten Subpixeln (02) und eine Vielzahl von dritten Subpixeln (03), wobei sich die Positionen aller vorgenannten Subpixel nicht gegenseitig überlappen;
eines der Vielzahl von ersten Subpixeln (01) sich an der Mittelposition eines ersten virtuellen Rechtecks befindet, und vier der Vielzahl von ersten Subpixeln (01) sich jeweils an vier Scheitelwinkelpositionen des ersten virtuellen Rechtecks befinden;
vier der Vielzahl von zweiten Subpixeln (02) sich jeweils an den Mittelpositionen von vier Seiten des ersten virtuellen Rechtecks befinden;
das erste virtuelle Rechteck in vier zweite virtuelle Rechtecke unterteilt ist, und das Innere jedes der vier zweiten virtuellen Rechtecke ein drittes Subpixel (03) aus der Vielzahl von dritten Subpixeln (03) umfasst;
das zweite virtuelle Rechteck durch aufeinanderfolgendes Verbinden von vier Scheitelwinkeln gebildet wird, und die vier Scheitelwinkel zwei zweite Subpixel (02) und zwei erste Subpixel (01) umfassen; die zwei zweiten Subpixel (02) sich an den Mittelpositionen von zwei benachbarten Seiten des ersten virtuellen Rechtecks befinden, jedes der zwei ersten Subpixel (01) benachbart ist zu jedem der zwei zweiten Subpixel (02), und eines der zwei ersten Subpixel (01) sich an der Mittelposition des ersten virtuellen Rechtecks befindet und das andere sich an einer Scheitelwinkelposition des ersten virtuellen Rechtecks befindet;
jedes erste Subpixel (01) die Form eines Rhombus oder eines Quadrats aufweist, wobei die Mitte von vier Seiten einen konkaven Abschnitt aufweist;
**dadurch gekennzeichnet, dass** die konkave Tiefe und Form des konkaven Abschnitts an die zwei Enden des länglichen Streifens des dritten Subpixels (03), das eine längliche Streifenform aufweist, angepasst sind.

2. Die Pixelanordnungsstruktur nach Anspruch 1, wobei das erste virtuelle Rechteck eine erste diagonale Linie und eine zweite diagonale Linie aufweist, die dritten Subpixel (03) in den zwei zweiten virtuellen Rechtecken, die entlang der ersten diagonalen Linie angeordnet sind, sich entlang der ersten diagonalen Linie erstrecken, und die dritten Subpixel (03) in den zwei zweiten virtuellen Rechtecken, die entlang der zweiten diagonalen Linie angeordnet sind, sich entlang der zweiten diagonalen Linie erstrecken.

3. Die Pixelanordnungsstruktur nach Anspruch 2, wobei die längliche Streifenform spiegelsymmetrisch in Bezug auf eine Symmetrieachse entlang einer Richtung senkrecht zu der Erstreckungsrichtung der länglichen Streifenform ist.

4. Die Pixelanordnungsstruktur nach Anspruch 2, wobei die dritten Subpixel (03) in den zwei zweiten virtuellen Rechtecken, die entlang der ersten diagonalen Linie angeordnet sind, spiegelsymmetrisch in Bezug auf die zweite diagonale Linie sind; die dritten Subpixel (03) in den zwei zweiten virtuellen Rechtecken, die entlang der zweiten diagonalen Linie angeordnet sind, spiegelsymmetrisch in Bezug auf die erste diagonale Linie sind.

5. Die Pixelanordnungsstruktur nach Anspruch 2, wobei ein erstes Verhältnis zwischen dem minimalen Abstand (D1) zwischen den gegenüberliegenden Seiten des dritten Subpixels (03) und des benachbarten ersten Subpixels (01) und dem minimalen Abstand (D2) zwischen den gegenüberliegenden Seiten des dritten Subpixels (03) und des benachbarten zweiten Subpixels (02) besteht; ein zweites Verhältnis zwischen dem minimalen Abstand (D1) zwischen den gegenüberliegenden Seiten des dritten Subpixels (03) und des benachbarten ersten Subpixels (01) und dem minimalen Abstand (D3) zwischen den gegenüberliegenden Seiten des ersten Subpixels (01) und des benachbarten zweiten Subpixels (02) besteht; ein drittes Verhältnis zwischen dem minimalen Abstand (D2) zwischen den gegenüberliegenden Seiten des dritten Subpixels (03) und des benachbarten zweiten Subpixels (02) und dem minimalen Abstand (D3) zwischen den gegenüberliegenden Seiten des ersten Subpixels (01) und des benachbarten zweiten Subpixels (02) besteht; wobei das erste Verhältnis, das zweite Verhältnis und das dritte Verhältnis alle in dem Bereich von 0,8-1,2 liegen.

6. Die Pixelanordnungsstruktur nach Anspruch 5, wobei das erste Verhältnis, das zweite Verhältnis und das dritte Verhältnis gleich sind.

7. Die Pixelanordnungsstruktur nach Anspruch 5, wobei das Verhältnis eines maximalen Abstands zwischen den gegenüberliegenden Seiten des dritten Subpixels (03) und des benachbarten ersten Subpixels (01) zu einem minimalen Abstand zwischen den gegenüberliegenden Seiten des dritten Subpixels (03) und des benachbarten ersten Subpixels (01) in einem Bereich von 1~1,5 liegt;
das Verhältnis eines maximalen Abstands zwischen den gegenüberliegenden Seiten des dritten Subpixels (03) und des benachbarten zweiten Subpixels (02) zu einem minimalen Abstand zwischen den gegenüberliegenden Seiten des dritten Subpixels (03) und des benachbarten zweiten Subpixels (02) in einem Bereich von 1~1,5 liegt.

8. Die Pixelanordnungsstruktur nach Anspruch 5, wobei die gegenüberliegenden Seiten des dritten Subpixels (03) und der benachbarten ersten Subpixel (01) parallel zueinander sind; die gegenüberliegenden Seiten des dritten Subpixels (03) und der benachbarten zweiten Subpixel (02) parallel zueinander sind.

9. Die Pixelanordnungsstruktur nach Anspruch 1, wobei jeder Innenwinkel des ersten Subpixels (01) größer oder gleich 90 Grad ist, wobei vorzugsweise die vier Scheitelwinkel des Rhombus oder des Quadrats abgerundete Ecken sind.

10. Die Pixelanordnungsstruktur nach Anspruch 1, wobei das erste Subpixel (01) ein rotes Subpixel ist; das zweite Subpixel (02) ein blaues Subpixel ist; das dritte Subpixel (03) ein grünes Subpixel ist;
die Fläche des blauen Subpixels jeweils größer als die Fläche des roten Subpixels und die Fläche des grünen Subpixels ist.

11. Die Pixelanordnungsstruktur nach Anspruch 2, wobei der Mittelpunkt des dritten Subpixels (03) jedes zweiten virtuellen Rechtecks sich an dem Schnittpunkt der Verbindungslinie zwischen den Mittelpunkten der zwei benachbarten ersten Subpixel (01) des entsprechenden zweiten virtuellen Rechtecks und der Verbindungslinie zwischen den Mittelpunkten der zwei benachbarten zweiten Subpixel (02) des entsprechenden zweiten virtuellen Rechtecks befindet.

12. Eine organische lichtemittierende Dioden-Anzeigetafel, umfassend die Vielzahl von Pixelanordnungsstrukturen nach einem der Ansprüche 1 bis 11;
wobei die benachbarten ersten virtuellen Rechtecke konfiguriert sind, sich die Subpixel auf jeweiligen einander zugewandten Seiten in der Zeilenrichtung und der Spaltenrichtung zu teilen.

13. Die organische lichtemittierende Dioden-Anzeigetafel nach Anspruch 12, wobei für die gesamte Tafel ein gesamtes Flächenverhältnis der ersten Sub-Subpixel (01), der zweiten Subpixel (02) und der dritten Subpixel (03) 1:(1,1~1,5):(1,2~1,7) beträgt.

## Revendications

1. Structure d'agencement de pixel, comprenant :
une pluralité de premiers sous-pixels (01), une pluralité de deuxièmes sous-pixels (02) et une pluralité de troisièmes sous-pixels (03), les positions de tous les sous-pixels ci-dessus ne se chevauchent pas les unes les autres ;
l'un de la pluralité de premiers sous-pixels (01) est situé à la position centrale d'un premier rectangle virtuel, et quatre de la pluralité de premiers sous-pixels (01) sont situés respectivement à quatre positions d'angle de sommet du premier rectangle virtuel ;
quatre de la pluralité de deuxièmes sous-pixels (02) sont situés respectivement aux positions centrales de quatre côtés du premier rectangle virtuel ;
le premier rectangle virtuel est divisé en quatre seconds rectangles virtuels, et l'intérieur de chacun des quatre seconds rectangles virtuels comprenant un troisième sous-pixel (03) de la pluralité de troisièmes sous-pixels (03) ;
le second rectangle virtuel est formé en reliant séquentiellement quatre angles de sommet, et les quatre angles de sommet comprennent deux deuxièmes sous-pixels (02) et deux premiers sous-pixels (01) ; les deux deuxièmes sous-pixels (02) sont situés aux positions centrales de deux côtés adjacents du premier rectangle virtuel, chacun des deux premiers sous-pixels (01) est adjacent à chacun des deux deuxièmes sous-pixels (02), et l'un des deux premiers sous-pixels (01) est situé à la position centrale du premier rectangle virtuel et l'autre est situé à une position d'angle de sommet du premier rectangle virtuel ;
chaque premier sous-pixel (01) a une forme d'un losange ou d'un carré dont le milieu de quatre côtés présente une partie concave ;
**caractérisée en ce que** la profondeur et la forme concaves de la partie concave sont en correspondance avec les deux extrémités de la longue bande du troisième sous-pixel ayant une forme de longue bande (03).

2. Structure d'agencement de pixel selon la revendication 1, dans laquelle le premier rectangle virtuel présente une première ligne diagonale et une seconde ligne diagonale, les troisièmes sous-pixels (03) dans les deux seconds rectangles virtuels disposés le long de la première ligne diagonale sont étendus le long de la première ligne diagonale, et les troisièmes sous-pixels (03) dans les deux seconds rectangles virtuels disposés le long de la seconde ligne diagonale sont étendus le long de la seconde ligne diagonale.

3. Structure d'agencement de pixel selon la revendication 2, dans laquelle la forme de longue bande présente une symétrie miroir par rapport à un axe de symétrie le long d'une direction perpendiculaire à la direction d'extension de la forme de longue bande.

4. Structure d'agencement de pixel selon la revendication 2, dans laquelle les troisièmes sous-pixels (03) dans les deux seconds rectangles virtuels qui sont disposés le long de la première ligne diagonale présentent une symétrie miroir par rapport à la seconde ligne diagonale ; les troisièmes sous-pixels (03) dans les deux seconds rectangles virtuels qui sont disposés le long de la seconde ligne diagonale présentent une symétrie miroir par rapport à la première ligne diagonale.

5. Structure d'agencement de pixel selon la revendication 2, dans laquelle il existe un premier rapport entre la distance minimale (D1) qui est entre les côtés opposés du troisième sous-pixel (03) et du premier sous-pixel (01) adjacent, et la distance minimale (D2) qui est entre les côtés opposés du troisième sous-pixel (03) et du deuxième sous-pixel (02) adjacent ; il existe un deuxième rapport entre la distance minimale (D1) qui est entre les côtés opposés du troisième sous-pixel (03) et du premier sous-pixel (01) adjacent, et la distance minimale (D3) qui est entre les côtés opposés du premier sous-pixel (01) et du deuxième sous-pixel (02) adjacent ; il existe un troisième rapport entre la distance minimale (D2) qui est entre les côtés opposés du troisième sous-pixel (03) et du deuxième sous-pixel (02) adjacent, et la distance minimale (D3) qui est entre les côtés opposés du premier sous-pixel (01) et du deuxième sous-pixel (02) adjacent ; le premier rapport, le deuxième rapport et le troisième rapport sont tous dans la plage de 0,8 à 1,2.

6. Structure d'agencement de pixel selon la revendication 5, dans laquelle le premier rapport, le deuxième rapport et le troisième rapport sont égaux.

7. Structure d'agencement de pixel selon la revendication 5, dans laquelle le rapport entre une distance maximale entre les côtés opposés du troisième sous-pixel (03) et du premier sous-pixel (01) adjacent et une distance minimale entre les côtés opposés du troisième sous-pixel (03) et du premier sous-pixel (01) adjacent est dans une plage de 1~1,5 ;
le rapport entre une distance maximale entre les côtés opposés du troisième sous-pixel (03) et du deuxième sous-pixel (02) adjacent et une distance minimale entre les côtés opposés du troisième sous-pixel (03) et du deuxième sous-pixel (02) adjacent est dans une plage de 1~1,5.

8. Structure d'agencement de pixel selon la revendication 5, dans laquelle les côtés opposés du troisième sous-pixel (03) et des premiers sous-pixels (01) adjacents sont parallèles les uns aux autres ; les côtés opposés du troisième sous-pixel (03) et des deuxièmes sous-pixels (02) adjacents sont parallèles les uns aux autres.

9. Structure d'agencement de pixel selon la revendication 1, dans laquelle chaque angle interne du premier sous-pixel (01) est supérieur ou égal à 90 degrés, de préférence, les quatre angles de sommet du losange ou du carré sont des coins arrondis.

10. Structure d'agencement de pixel selon la revendication 1, dans laquelle le premier sous-pixel (01) est un sous-pixel rouge ; le deuxième sous-pixel (02) est un sous-pixel bleu ; le troisième sous-pixel (03) est un sous-pixel vert ;
la surface du sous-pixel bleu est plus grande que la surface du sous-pixel rouge et que la surface du sous-pixel vert, respectivement.

11. Structure d'agencement de pixel selon la revendication 2, dans laquelle le centre du troisième sous-pixel (03) de chaque second rectangle virtuel est situé à l'intersection de la ligne reliant les centres des deux premiers sous-pixels (01) adjacents du second rectangle virtuel correspondant et de la ligne reliant les centres des deux deuxièmes sous-pixels (02) adjacents du second rectangle virtuel correspondant.

12. Panneau d'affichage à diodes luminescentes organiques, comprenant la pluralité de structures d'agencement de pixel selon l'une des revendications 1 à 11 ;
dans lequel les premiers rectangles virtuels adjacents sont configurés pour partager les sous-pixels sur des côtés en vis-à-vis respectifs dans la direction de rangée et la direction de colonne.

13. Panneau d'affichage à diodes luminescentes organiques selon la revendication 12, dans lequel, pour le panneau global, un rapport de surface total des premiers sous-sous-pixels (01), des deuxièmes sous-pixels (02) et des troisièmes sous-pixels (03) est de 1:(1,1~1,5):(1,2~1,7).
